# FASCICULE DE BREVET EUROPEEN

(11) **EP 2 409 553 B1**
(45) Date de publication et mention de la délivrance du brevet: **17.01.2018**
(21) Numéro de dépôt: 10706267.1
(22) Date de dépôt: 05.03.2010
(51) Int. Cl.: H05K 5/00, H05K 7/14, H02M 7/00

(54) **ENSEMBLE DE COMMANDE COMPORTANT UN VARIATEUR DE VITESSE ET UN DISJONCTEUR**
STEUERBAUGRUPPE MIT EINEM ANTRIEB VARIABLER GESCHWINDIGKEIT UND EINEM UNTERBRECHERSCHALTER
CONTROL ASSEMBLY COMPRISING A VARIABLE-SPEED DRIVE AND A CIRCUIT-BREAKER

(30) Priorité: 18.03.2009 FR 0951718
(43) Date de publication de la demande: 25.01.2012
(73) Titulaire: Schneider Toshiba Inverter Europe SAS, 27120 Pacy sur Eure (FR)
(72) Inventeur: BARREAU, Jérôme, F-92506 Rueil Malmaison Cedex (FR); LEON, Frédéric, F-27810 Marcilly Sur Eure (FR)
(74) Mandataire: Dufresne, Thierry
(86) Numéro de dépôt international: PCT/EP2010/052794
(87) Numéro de publication internationale: WO 2010/105920

(56) Documents cités:
- EP-A- 0 659 040
- EP-A- 0 660 652
- EP-A2- 2 048 926
- US-A- 4 769 557
- US-A1- 2005 180 814
- US-A1- 2005 189 889

## Description

La présente invention se rapporte à un ensemble de commande comportant un variateur de vitesse et un appareil électrique interrupteur tel qu'un contacteur électromécanique ou un disjoncteur de protection.

Il est connu de réaliser un ensemble de commande comportant un variateur de vitesse destiné à commander une charge électrique et un appareil électrique interrupteur tel que par exemple un disjoncteur de protection. Dans cet ensemble, le variateur de vitesse comporte notamment un bornier de puissance recevant du courant de puissance par des lignes de courant et le disjoncteur est connecté sur les lignes de courant pour protéger le variateur de vitesse en cas de surcharge ou de court-circuit.

En règle générale, le variateur de vitesse est fixé sur un support à l'aide de moyens de fixation et le disjoncteur est également fixé sur le même support, en étant par exemple accroché à un rail DIN. Dans cette situation, le disjoncteur doit être fixé sur le support à une certaine distance, au-dessus ou au-dessous du variateur ce qui rend l'ensemble particulièrement encombrant. De plus, comme la profondeur du variateur est bien plus importante que celle du disjoncteur et que les deux appareils sont fixés sur le même support, l'organe de manoeuvre du disjoncteur se trouve être difficilement accessible, au fond de l'armoire par exemple.

Le document US4769557 décrit un variateur de vitesse sur lequel il est possible de venir fixer un module de protection. Le module de protection est spécialement configuré pour être attaché sur le variateur de vitesse. Le document US 2005/189889 A1 décrit un ensemble de commande selon le préambule de la revendication 1. Le but de l'invention est de proposer un ensemble de commande comportant un variateur de vitesse sur lequel il est possible de venir fixer un appareil électrique interrupteur pouvant avoir différentes tailles ou formes. L'ensemble de commande est particulièrement peu encombrant et l'appareil électrique interrupteur peut y être manoeuvré aisément.

Ce but est atteint par un ensemble de commande comportant :
- un variateur de vitesse destiné à commander une charge électrique, ledit variateur comportant à l'arrière des moyens de fixation pour être fixé sur un support et comportant un bornier de puissance recevant du courant de puissance par des lignes de courant,
- un appareil électrique interrupteur connecté sur les lignes de courant pour commander ou protéger le variateur de vitesse,
- l'appareil électrique interrupteur étant connecté électriquement sur le bornier de puissance du variateur de vitesse et,
- l'ensemble de commande comportant des moyens de fixation pour fixer mécaniquement l'appareil électrique interrupteur uniquement sur le variateur de vitesse,
- les moyens de fixation comportant une pièce-support (40) intermédiaire comportant une première partie (400) destinée à être fixée sur la face supérieure (102) du variateur de vitesse (10) et une seconde partie (401) sur laquelle est fixé l'appareil électrique interrupteur.

Selon l'invention, l'appareil électrique interrupteur est un contacteur électromécanique ou un disjoncteur de protection.

Selon une particularité, le disjoncteur est fixé sur la partie avant du variateur de vitesse.

Selon une autre particularité, l'encombrement en largeur du variateur de vitesse est identique à celui du disjoncteur de protection.

Selon une autre particularité, les moyens de fixation comportent une pièce-support en forme générale de L comportant une première partie destinée à être fixée sur la face supérieure du variateur de vitesse et une seconde partie sur laquelle est fixé le disjoncteur.

Selon une autre particularité, la pièce-support est fixée sur la face supérieure du variateur de vitesse par l'intermédiaire de vis, le disjoncteur fixé sur la pièce-support masquant lesdites vis.

Selon une autre particularité, la seconde partie de la pièce-support comporte un organe d'accrochage sur lequel peut venir se fixer le disjoncteur à l'aide de moyens de fixation adaptés.

Selon une autre particularité, l'ensemble de commande comporte une pièce d'interconnexion électrique permettant de connecter électriquement le disjoncteur sur le bornier de puissance du variateur de vitesse.

D'autres caractéristiques et avantages vont apparaître dans la description détaillée qui suit en se référant à un mode de réalisation donné à titre d'exemple et représenté par les dessins annexés sur lesquels :

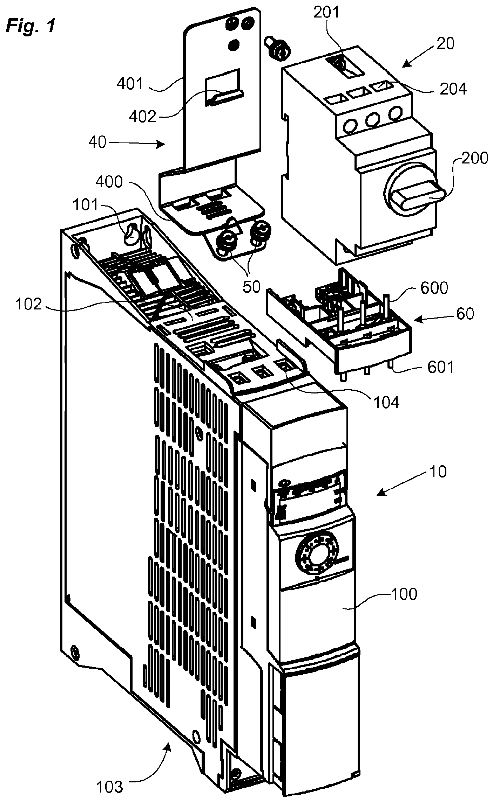

- la figure 1 représente une vue en éclaté de l'ensemble de commande de l'invention,

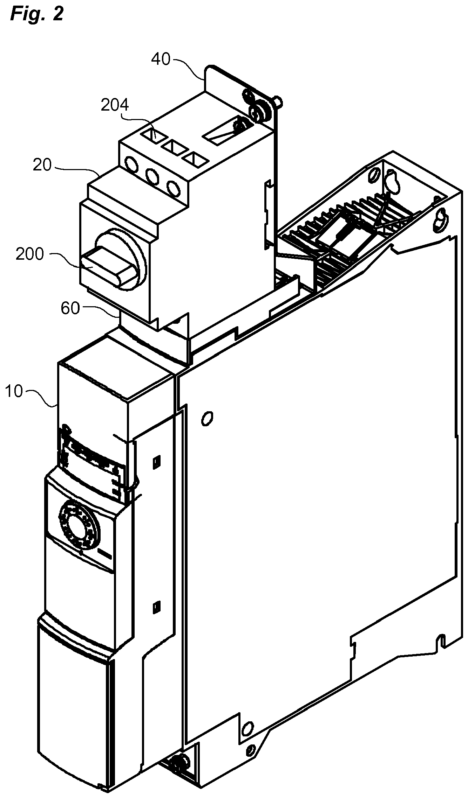

- la figure 2 représente l'ensemble de commande de l'invention assemblé,
- la figure 3 représente en vue de côté l'ensemble de commande de l'invention.

L'invention concerne un ensemble de commande comportant un variateur de vitesse 10 et un appareil électrique interrupteur tel que par exemple un contacteur électromécanique ou un disjoncteur de protection.

Dans la suite de la description, l'appareil électrique interrupteur décrit est un disjoncteur 20 de protection. Il faut comprendre que l'invention peut tout à fait s'adapter à un appareil électrique interrupteur de type contacteur électromécanique.

Dans la suite de la description, on entend par "partie avant" et "partie arrière", les parties du variateur de vitesse délimitées par un plan de coupe vertical médian par rapport à la profondeur du variateur de vitesse.

De manière connue, un variateur de vitesse 10 est destiné à commander une charge électrique (non représentée) et comporte un bornier de puissance sur lequel viennent se connecter des lignes de courant de puissance. Le bornier de puissance comporte des bornes de puissance amont (hautes) 104 et des bornes de puissance aval (basses-non visibles sur les figures).

Le disjoncteur de protection 20 est connecté sur les lignes de courant de puissance et comporte un bornier de puissance ayant également des bornes de puissance amont (hautes) 204 et des bornes de puissance aval (basses - non visibles sur les figures). Les lignes de courant de puissance sont connectées sur les bornes de puissance amont 204 du disjoncteur.

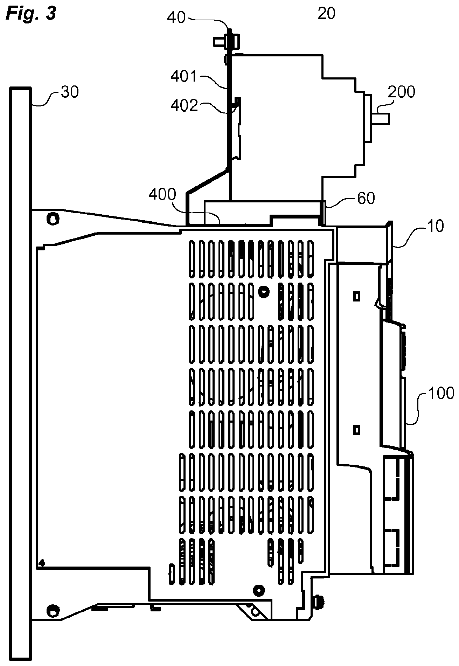

Le variateur de vitesse comporte typiquement une partie avant et une partie arrière. La partie avant comporte une façade de commande 100 et la partie arrière comporte des moyens de fixation 101 permettant de fixer le variateur de vitesse par l'arrière sur un support 30 (figure 3). Le variateur de vitesse 10 comporte en outre une face supérieure 102 sur laquelle sont réalisées les bornes de puissance amont 104 et une face inférieure 103 sur laquelle sont réalisées les bornes de puissance aval. Les bornes de puissance sont réalisées sur la partie avant du variateur de vitesse 10.

Selon l'invention, le disjoncteur 20 n'est pas fixé sur un support tel que le support 30 recevant le variateur de vitesse 10 mais est fixé directement sur le variateur de vitesse 10 et uniquement au variateur de vitesse 10. Pour cela, l'ensemble de commande comporte des moyens de fixation permettant de fixer le disjoncteur 20 sur le variateur de vitesse 10. Ces moyens de fixation comportent une pièce-support 40 métallique ayant une forme générale en L définissant une première partie 400 destinée à être fixée sur la face supérieure 102 du variateur de vitesse et une seconde partie 401 sensiblement perpendiculaire à la première partie et sur laquelle le disjoncteur 20 est fixé par l'arrière grâce à des moyens de fixation adaptés. L'emploi d'une pièce de fixation intermédiaire entre le variateur de vitesse 10 et le disjoncteur 20 permet de pouvoir accrocher des disjoncteurs de différentes tailles et donc de différents calibres sans réaliser des moyens d'accrochage spécifiques sur le variateur de vitesse 10. Sur la face supérieure 102 du variateur de vitesse 10, sur sa partie avant, la pièce-support 40 est par exemple fixée grâce à deux vis 50 traversant une partie inclinée prolongeant sa première partie 400. Les vis 50 viennent par exemple se loger dans un renfoncement réalisé sur la face supérieure 102 du variateur de vitesse 10. Un ou plusieurs ergots peuvent être prévus sur la pièce support pour assurer son positionnement et son accrochage sur des formes complémentaires réalisées sur la face supérieure 102 du variateur de vitesse. Lorsque le disjoncteur 20 est fixé sur la pièce-support 40, celui-ci masque les vis 50 de fixation de la pièce-support sur la face supérieure 102 du variateur de vitesse 10. Ainsi, il est impossible de démonter la pièce-support 40 alors que le disjoncteur 20 est encore monté sur la pièce-support 40.La seconde partie 401 de la pièce-support 40 comporte un organe d'accrochage 402 destiné à recevoir les moyens de fixation adaptés du disjoncteur 20. Les moyens de fixation du disjoncteur 20 sont ceux habituellement utilisés par le disjoncteur 20 pour s'accrocher sur un rail DIN. De plus, le disjoncteur 20 peut également être fixé sur la seconde partie 401 de la pièce-support 40 à l'aide d'une vis 201.

Selon l'invention, comme le disjoncteur 20 est fixé sur la partie avant du variateur de vitesse 10, son organe de manoeuvre 200 se trouve être très accessible et suffisamment avancé pour être sensiblement au même niveau que la façade de commande 100 du variateur de vitesse 10.

En outre, l'ensemble de commande comporte une pièce d'interconnexion 60 destinée à se positionner en partie entre la première partie 400 de la pièce-support 40 et le disjoncteur 20 et s'étendant au-delà de la première partie 400 de la pièce support 40 afin de pouvoir assurer l'interconnexion électrique entre le disjoncteur 20 et le variateur de vitesse 10 sans utiliser de fils. Cette pièce d'interconnexion 60 comporte des broches hautes 600 destinées à s'engager dans les bornes de puissance aval du disjoncteur 20 et des broches basses 601 destinées à s'engager dans les bornes de puissance amont 104 du variateur de vitesse 10. Les broches de la pièce d'interconnexion sont fixes mais peuvent très bien être réglables pour s'adapter à des pas interbornes variables des deux appareils. La pièce d'interconnexion 60 peut également comporter des moyens de fixation lui permettant de recevoir et de fixer le disjoncteur 20.

Selon l'invention, le variateur de vitesse 10 présente l'avantage d'avoir un encombrement en largeur identique ou au moins presque identique (à +/- 0,5 mm près) à celui du disjoncteur 20. Ceci est permis grâce à un agencement interne particulier du variateur de vitesse 10. De même, la pièce-support 40 présente approximativement le même encombrement en largeur que le disjoncteur 20 et le variateur de vitesse 10. De cette manière l'ensemble de commande de l'invention est particulièrement compact.

## Revendications

1. Ensemble de commande comportant :
- un variateur de vitesse (10) destiné à commander une charge électrique, ledit variateur comportant à l'arrière des moyens de fixation (101) pour être fixé sur un support (30) et comportant un bornier de puissance recevant du courant de puissance par des lignes de courant,
- un appareil électrique interrupteur connecté sur les lignes de courant pour commander ou protéger le variateur de vitesse (10),
- des moyens de fixation pour fixer mécaniquement l'appareil électrique interrupteur uniquement sur le variateur de vitesse (10),
- l'appareil électrique interrupteur étant connecté électriquement sur le bornier de puissance du variateur de vitesse et **caractérisé en ce que** :
- les moyens de fixation comportent une pièce-support (40) intermédiaire comportant une première partie (400) destinée à être fixée sur la face supérieure (102) du variateur de vitesse (10) et une seconde partie (401) sur laquelle est fixé l'appareil électrique interrupteur.

2. Ensemble de commande selon la revendication 1, **caractérisé en ce que** l'appareil électrique interrupteur est un contacteur électromécanique ou un disjoncteur de protection (20).

3. Ensemble de commande selon la revendication 2, **caractérisé en ce que** le disjoncteur (20) est fixé sur la partie avant du variateur de vitesse (10).

4. Ensemble de commande selon la revendication 2 ou 3, **caractérisé en ce que** l'encombrement en largeur du variateur de vitesse (10) est identique à celui du disjoncteur de protection (20).

5. Ensemble de commande selon l'une des revendications 2 à 4, **caractérisé en ce que** la pièce-support (40) présente une forme générale en L définie par sa première partie (400) destinée à être fixée sur la face supérieure (102) du variateur de vitesse (10) et sa seconde partie (401) sur laquelle est fixé le disjoncteur (20).

6. Ensemble de commande selon la revendication 5, **caractérisé en ce que** la seconde partie (401) de la pièce-support (40) comporte un organe d'accrochage (402) sur lequel peut venir se fixer le disjoncteur (20) à l'aide de moyens de fixation adaptés.

7. Ensemble de commande selon la revendication 5 ou 6, **caractérisé en ce que** la pièce-support (40) est fixée sur la face supérieure du variateur de vitesse par l'intermédiaire de vis (50) et **en ce que** le disjoncteur (20) fixé sur la pièce-support (40) masque lesdites vis (50).

8. Ensemble de commande selon l'une des revendications 2 à 7, **caractérisé en ce qu'**il comporte une pièce d'interconnexion électrique (60) permettant de connecter électriquement le disjoncteur (20) sur le bornier de puissance du variateur de vitesse (10).

## Patentansprüche

1. Steuerbaugruppe, umfassend:
- einen Umrichter (10), der dazu bestimmt ist, eine elektrische Last zu steuern, wobei der Umrichter an der Rückseite Befestigungsmittel (101) aufweist, um an einer Stütze (30) befestigt zu werden, und einen Leistungsanschlussblock aufweist, der über Stromleitungen Leistungsstrom empfängt,
- ein elektrisches Schaltgerät, das an die Stromleitungen angeschlossen ist, um den Umrichter (10) zu steuern oder zu schützen,
- Befestigungsmittel zum mechanischen Befestigen des elektrischen Schaltgeräts ausschließlich an dem Umrichter (10),
- wobei das elektrische Schaltgerät an den Leistungsanschlussblock des Umrichters elektrisch angeschlossen ist, und
**dadurch gekennzeichnet ist, dass**:
- die Befestigungsmittel ein Zwischenstützteil (40) umfassen, das einen ersten Teil (400), der dazu bestimmt ist, auf der Oberseite (102) des Umrichters (10) befestigt zu werden, und einen zweiten Teil (401), an welchem das elektrische Schaltgerät befestigt ist, aufweist.

2. Steuerbaugruppe nach Anspruch 1, **dadurch gekennzeichnet, dass** das elektrische Schaltgerät ein elektromechanisches Schütz oder ein Schutzschalter (20) ist.

3. Steuerbaugruppe nach Anspruch 2, **dadurch gekennzeichnet, dass** der Schutzschalter (20) am vordere Teil des Umrichters (10) befestigt ist.

4. Steuerbaugruppe nach Anspruch 2 oder 3, **dadurch gekennzeichnet, dass** die Baubreite des Umrichters (10) mit derjenigen des Schutzschalters (20) identisch ist.

5. Steuerbaugruppe nach einem der Ansprüche 2 bis 4, **dadurch gekennzeichnet, dass** das Stützteil (40) eine im Wesentlichen L-förmige Gestalt aufweist, die durch seinen ersten Teil (400), der dazu bestimmt ist, auf der Oberseite (102) des Umrichters (10) befestigt zu werden, und seinen zweiten Teil (401), an welchem der Schutzschalter (20) befestigt ist, definiert ist.

6. Steuerbaugruppe nach Anspruch 5, **dadurch gekennzeichnet, dass** der zweite Teil (401) des Stützteils (40) ein Aufhängeelement (402) aufweist, an welchem der Schutzschalter (20) mithilfe geeigneter Befestigungsmittel befestigt werden kann.

7. Steuerbaugruppe nach Anspruch 5 oder 6, **dadurch gekennzeichnet, dass** das Stützteil (40) auf der Oberseite des Umrichters mit Schrauben (50) befestigt ist, und dadurch, dass der an dem Stützteil (40) befestigte Schutzschalter (20) diese Schrauben (50) verdeckt.

8. Steuerbaugruppe nach einem der Ansprüche 2 bis 7, **dadurch gekennzeichnet, dass** sie ein elektrisches Verbindungsteil (60) aufweist, welches ermöglicht, den Schutzschalter (20) an den Leistungsanschlussblock des Umrichters (10) elektrisch anzuschließen.

## Claims

1. A control assembly comprising:
- a variable speed drive (10) designed to control an electric load, said variable speed drive including, at the rear, fixing means (101) to be fixed to a support (30) and including a power terminal block receiving power current via current lines,
- an electric switching device connected to the current lines to control or protect the variable speed drive (10),
- fixing means for mechanically fixing the electric switching device only to the variable speed drive (10),
- the electric switching device being electrically connected to the power terminal block of the variable speed drive and **characterized in that**:
- the fixing means include an intermediate support piece (40) comprising a first part (400) intended to be fixed to the top face (102) of the variable speed drive (10) and a second part (401) to which the electric switching device is fixed.

2. The control assembly as claimed in claim 1, **characterized in that** the electric switching device is an electromechanical contactor or a protection circuit breaker (20).

3. The control assembly as claimed in claim 2, **characterized in that** the circuit breaker (20) is fixed to the front part of the variable speed drive (10).

4. The control assembly as claimed in claim 2 or 3, **characterized in that** the widthwise bulk of the variable speed drive (10) is identical to that of the protection circuit breaker (20).

5. The control assembly as claimed in one of claims 2 to 4, **characterized in that** the support piece (40) has a general L-shape defined by its first part (400) intended to be fixed to the top face (102) of the variable speed drive (10) and its second part (401) to which the circuit breaker (20) is fixed.

6. The control assembly as claimed in claim 5, **characterized in that** the second part (401) of the support piece (40) comprises an attachment unit (402) to which the circuit breaker (20) can be fixed using suitable fixing means.

7. The control assembly as claimed in claim 5 or 6, **characterized in that** the support piece (40) is fixed to the top face of the variable speed drive via screws (50) and **in that** the circuit breaker (20) fixed to the support piece (40) masks said screws (50).

8. The control assembly as claimed in one of claims 2 to 7, **characterized in that** it includes an electric interconnection piece (60) making it possible to electrically connect the circuit breaker (20) to the power terminal block of the variable speed drive (10).
